# EUROPEAN PATENT SPECIFICATION

(11) **EP 0 318 011 B1**
(45) Date of publication and mention of the grant of the patent: **19.01.1994**
(21) Application number: 88119609.1
(22) Date of filing: 24.11.1988
(51) Int. Cl.: G11C 7/00

(54) **Semiconductor memory device with discharging circuit**
Halbleiterspeicher mit einer Entladungsschaltung
Mémoire semi-conductrice avec un circuit de décharge

(30) Priority: 27.11.1987 JP 300609/87
(43) Date of publication of application: 31.05.1989
(73) Proprietor: NEC CORPORATION, Tokyo (JP)
(72) Inventor: Adachi, Takao, Minato-ku Tokyo 108-01 (JP)
(74) Representative: Glawe, Delfs, Moll & Partner

(56) References cited:
- US-A- 3 699 537
- US-A- 3 848 236

## Description

This invention relates to a semiconductor memory device and, more particularly, to a discharging circuit provided in association with the bit lines for coupling unselected bit lines to the ground.

### BACKGROUND OF THE INVENTION

Conventionally, a semiconductor memory device comprises a plurality of memory cells arranged in rows and columns and respectively storing data bits, a plurality of bit lines each provided in association with the memory cells in each column, a plurality of word lines each coupled to the memory cells in each row for causing the memory cells to supply the bit lines with the data bits stored therein, a column selector circuit for propagating one of the data bits, and a output circuit for the data bit transferred from the column selector circuit.

In a read-out operation, one of the word lines is activated for causing the memory cells coupled thereto to supply the bit lines with the data bits, respectively, and the column selector circuit allows one of the data bits to be latched in the output circuit. Then, the data bit is supplied from the output circuit to a destination such as a micro-processor.

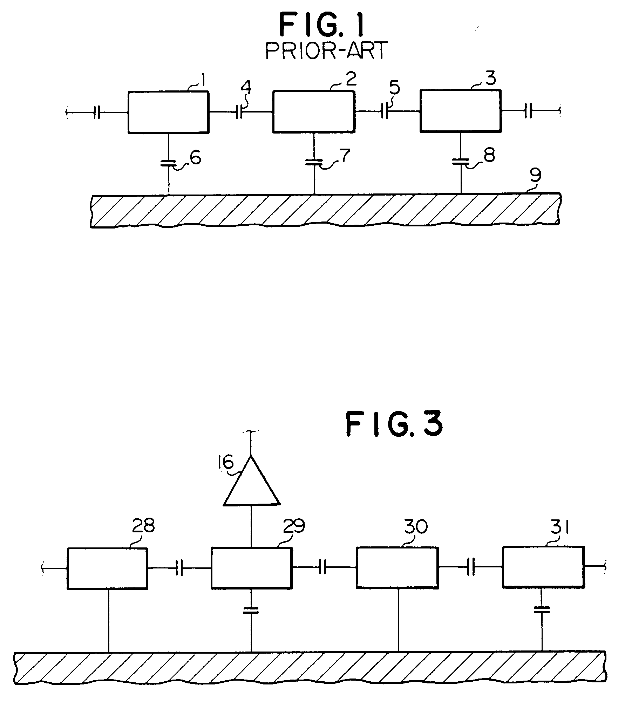

However, a problem is encountered in the prior-art semiconductor memory device in fluctuation of the voltage level on the bit lines. Recently, this problem becomes serious due to miniaturization of the memory cells. In detail, when the memory cells are reduced in size for increasing the integration density, the adjacent bit lines 1, 2 and 3 are decreased in gap therebetween as shown in Fig. 1. The narrower the gap therebetween, the larger the parasitic capacitance is coupled thereto. The unselected bit lines are isolated from the output circuit, so that the parasitic capacitances 4 and 5 should be taken into account as well as parasitic capacitances 6, 7 and 8 produced between the bit lines and the ground terminal 9.

### SUMMARY OF THE INVENTION

It is therefore an important object of the present invention to provide a semiconductor memory device which is free from the fluctuation of the voltage level on the bit lines.

To accomplish this object, the present invention proposes to couple the unselected bit lines to the ground.

In accordance with the present invention, there is provided a semiconductor memory device fabricated on a semiconductor substrate, comprising: a) a plurality of memory cells arranged in rows and columns and capable of storing data bits; b) a plurality of bit lines respectively coupled to the columns of memory cells for propagating the data bits read out from memory cells each selected from each column; c) a plurality of word lines respectively coupled to the rows of memory cells and selecting a row of memory cells for supplying the data bits to the bit lines; d) a row address decoder circuit operative to activate one of the word lines; e) a column address decoder circuit operative to produce a bit line selecting signal for specifying one of the bit lines, the bit line selecting signal having a plurality of bits; f) an output circuit operative to latch one of the data bits on said one of said bit lines; g) a column selector circuit responsive to the bit line selecting signal and operative to transfer the one of the data bits from the associated bit line to the output circuit; and h) a discharging circuit operative to couple at least the bit lines on both sides of and immediately adjacent to said one of said bit lines to a constant voltage source.

### BRIEF DESCRIPTION OF THE DRAWINGS

The features and advantages of a semiconductor memory device according to the present invention will be more clearly understood from the following description taken in conjunction with the accompanying drawings in which:
Fig. 1 is a block diagram showing, in a modeled form, the bit lines incorporated in a prior-art semiconductor memory device;
Fig. 2 is a diagram showing a part of the circuit arrangement of a semiconductor memory device embodying the present invention; and
Fig. 3 is a block diagram showing, in a modeled form, the bit lines incorporated in the semiconductor memory device illustrated in Fig. 2.

### DESCRIPTION OF THE PREFERRED EMBODIMENTS

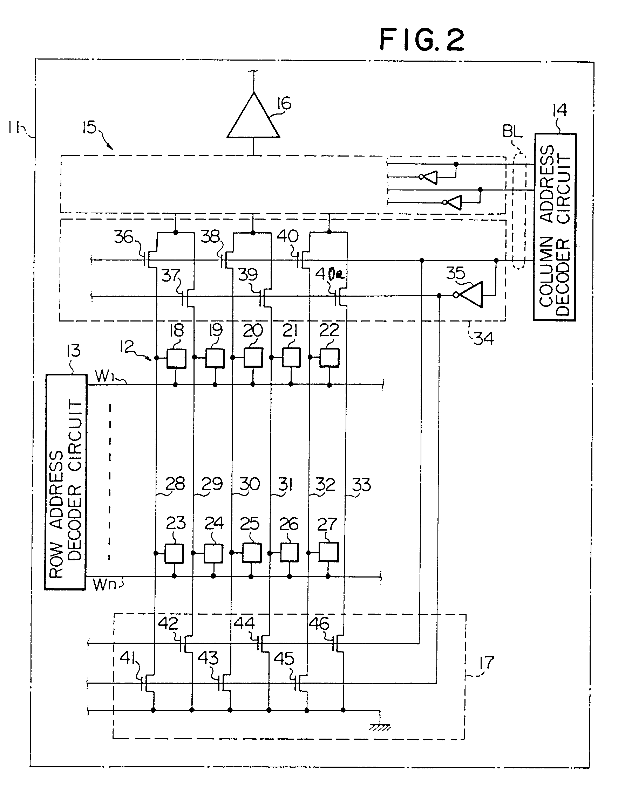

Referring first to Fig. 2 of the drawings, there is shown a part of the circuit arrangement of a semiconductor memory device embodying the present invention. The semiconductor memory device illustrated in Fig. 2 is fabricated on a semiconductor substrate 11 of, for example, single crystalline silicon and largely comprises a memory cell array 12, a row address decoder circuit 13, a column address decoder circuit 14, a column selector circuit 15, an output buffer circuit 16, and a discharging circuit 17.

The memory cell array 12 has a plurality of memory cells arranged in rows and columns, but the memory cells 18 to 27 in parts of the two rows are shown in the figure. The memory cells in each row are coupled to each of word lines W1 to Wn, and the row address decoder circuit 13 activates one of the word lines W1 to Wn on the basis of a row address signal supplied from the outside thereof. Moreover, the memory cells in each column are coupled to each of bit lines 28 to 33 which in turn are coupled to the column selector circuit 15. The column selector circuit 15 is provided with a plurality of stages including the first stage 34, and each of the stages have n-channel type field effect transistors provided in association with the bit lines 28 to 33, respectively, and an inverter circuit. For example, the first stage 34 has n-channel type field effect transistors 36 to 40a coupled to the bit lines 28 to 33, respectively. The column address decoder circuit 14 has a plurality of control lines equal in number to the stages of the column selector circuit 15, and a multi-bit bit line selecting signal BL is supplied to the control lines. Each of the control lines is associated with each of the stages and coupled directly to the gate electrodes of a half of the n-channel type field effect transistors and the inverter circuit 35 which is coupled to the gate electrodes of the other half of the n-channel type field effect transistors. Since each of the control lines is coupled to the gate electrode of every second one out of the n-channel type field effect transistors, the n-channel type field effect transistors coupled at the gate electrodes to the inverter circuit are arranged to be located on both sides of each n-channel type field effect transistor directly coupled to the control line.

As to the first stage 34, one of the control line is coupled to the gate electrodes of the n-channel type field effect transistors 36, 38 and 40, but the inverter circuit 35 is coupled to the gate electrodes of the n-channel type field effect transistors 37, 39 and 40a. Each of the stages thus arranged is operative to transfer a half of the data bits supplied thereto to the subsequent stage, so that only one of the data bits is supplied from the final stage of the column selector circuit 15 to the output buffer circuit 16.

The discharging circuit 17 has a plurality of n-channel type field effect transistors equal in number to the bit lines, so that the n-channel type field effect transistors 41 to 46 are coupled to the bit lines 28 to 33, respectively. The n-channel type field effect transistors 42, 44 and 46 are directly coupled to the gate electrodes of the n-channel type field effect transistors 42, 44 and 46, but the n-channel type field effect transistors 41, 43 and 45 are coupled at the gate electrodes thereof to the inverter circuit 35. All of the n-channel type field effect transistors 41 to 46 are coupled at the other ends thereof to a ground terminal. The n-channel type field effect transistors 41, 43 and 45 gated by the inverter circuit 35 are provided in association with the bit lines 28, 30 and 32 which in turn are provided in association with the n-channel type field effect transistors 36, 38 and 40. Similarly, the n-channel type field effect transistors 42, 44 and 46 gated by the control line are provided in association with the bit lines 29, 31 and 33, and the n-channel type field effect transistors 37, 39 and 40a are provided in association with the inverter circuit 35. Then, the n-channel type field effect transistors 41 to 46 corresponds to the n-channel type field effect transistors 36 to 41 in view of the bit lines 28 to 33, and the n-channel type field effect transistors 41 to 46 are complementarily shifted between the on-states and the off-states with respect to the n-channel type field effect transistors 36 to 40a.

Description is made for a read-out operation on the assumption that the memory cell 19 is accessed. The row address decoder circuit 13 shifts the word line W1 to the active high voltage level, and the column address decoder circuit 14 produces the multi-bit bit line selecting signal BL which has a bit of the low voltage level supplied to the control line provided in association with the first stage 34. When the word line W1 goes up to the active high voltage level, the data bits are supplied from the memory cells 18 to 22 to the bit lines 28 to 32, respectively. With the bit of the low voltage level, the n-channel type field effect transistors 36, 38 and 40 are turned off, so that data bits on the bit lines 28, 30 and 32 are blocked by the n-channel type field effect transistors 36, 38 and 40. On the other hand, the n-channel type field effect transistors 37 and 39 turn on to transfer the data bits on the bit lines 29 and 31 to the subsequent stage. Thus, the data bit on the bit line 29 is finally transferred to the output buffer circuit 16. With the bit of the low voltage level, the n-channel type field effect transistors 42, 44 and 46 remain off, however, the inverse of the bit is supplied from the inverter circuit 35 to the n-channel type field effect transistors 41, 43 and 45, so that the bit lines 28, 30 and 32 are grounded. In other words, the bit line 29 coupled to the accessed memory cell 19 is neighbored by the bit lines 28 and 30 coupled to the ground terminal as illustrated in Fig. 3. As a result, the total parasitic capacitance coupled to the bit line 29 is drastically reduced due to the elimination of capacitances each produced between the adjacent bit lines. Then, no fluctuation takes place in the voltage level on the bit line 29, and, for this reason, the data bit read out from the memory cell 19 is correctly transferred to the output circuit 16.

## Claims

1. A semiconductor memory device fabricated on a semiconductor substrate (11), comprising:
a) a plurality of memory cells (12) arranged in rows and columns and capable of storing data bits;
b) a plurality of bit lines (28 to 33) respectively coupled to the columns of said memory cells for propagating the data bits read out from memory cells each selected from each column,
c) a plurality of word lines (W1 to Wn) respectively coupled to the rows of said memory cells , and selecting a row of the memory cells for supplying said data bits to said bit lines;
d) a row address decoder circuit (13) operative to activate one of said word lines;
e) a column address decoder circuit (14) operative to produce a bit line selecting signal for specifying one of said bit lines, said bit line selecting signal having a plurality of bits;
f) an output circuit (16) operative to latch one of said data bits on said one of said bit lines; and
g) a column selector circuit (15) responsive to said bit line selecting signal and operative to transfer said one of said data bits from the associated bit line to said output circuit,
**characterized by**
h) a discharging circuit (17) operative to couple at least the bit lines on both sides of and immediately adjacent to said one of said bit lines to a constant voltage source.

2. A semiconductor memory device as set forth in claim 1, in which said column selector circuit (15) is provided with a plurality of stages including a first stage (34) coupled to said bit lines, the bits of said bit line selecting signal being supplied to said stages, respectively, and in which each of said stages has a plurality of n-channel type field effect transistors (36 to 41) coupled to said bit lines, respectively, and an inverter circuit (35) supplied with each of said bits, wherein each of said bits is supplied to the gate electrode of every second one out of said n-channel type field effect transistors of each stage and said inverter circuit is coupled to the gate electrodes of the other n-channel type field effect transistors of each stage.

3. A semiconductor memory device as set forth in claim 2, in which said discharging circuit (17) comprises a plurality of n-channel type field effect transistors (41 to 46) coupled to said bit lines, respectively, said n-channel type field effect transistors of said discharging circuit corresponding to said n-channel type field effect transistors of said first stage in view of said bit lines, and in which all of the n-channel type field effect transistors of said discharging circuit are coupled at the other ends thereof to a ground terminal, wherein said n-channel type field effect transistors of said discharging circuit corresponding to said n-channel type field effect transistors of said first stage supplied with the bit of said bit line selecting signal are coupled at the gate electrodes thereof to the inverter circuit of said first stage and the other n-channel type field effect transistors of said discharging circuit are supplied with said bit of said bit line selecting signal.

## Patentansprüche

1. Halbleiterspeichervorrichtung, die auf einem Halbleitersubstrat (11) gefertigt ist, mit:
a) einer Vielzahl von Speicherzellen (12), die in Zeilen und Spalten angeordnet sind und Datenbits speichern können,
b) einer Anzahl von Bitleitungen (28 - 33), die jeweils mit den Spalten der Speicherzellen verbunden sind, zur Weiterleitung der Datenbits, die aus den Speicherzellen ausgelesen wurden, die jeweils aus jeder Spalte ausgewählt wurden,
c) einer Anzahl Wortleitungen (W1 - Wn), die jeweils mit den Zeilen der Speicherzellen verbunden sind und die eine Zeile der Speicherzellen zur Lieferung der Datenbits an die Bitleitungen auswählen,
d) einer Zeilenadress-Dekoderschaltung (13) zur Aktivierung einer der Wortleitungen,
e) einer Spaltenadress-Dekoderschaltung (14) zur Erzeugung eines Bitleitungs-Auswahlsignals zur Bezeichnung einer der Bitleitungen, wobei das Bitleitungs-Auswahlsignal eine Anzahl von Bits aufweist,
f) einer Ausgangsschaltung (16) zum Halten eines der Datenbits auf einer der Bitleitungen und
g) einer Spaltenauswahlschaltung (15), die auf das Bitleitungs-Auswahlsignal anspricht, zur Übertragung des einen der Datenbits von der zugeordneten Bitleitung an die Ausgangsschaltung,
**gekennzeichnet** durch
h) eine Entladungsschaltung (17) zur Kopplung von zumindest den Bitleitungen an beiden Seiten und direkt angrenzend an die eine der Bitleitungen mit einer Konstantspannungsquelle.

2. Halbleiterspeichervorrichtung nach Anspruch 1,
wobei die Spaltenauswahlschaltung (15) mit einer Anzahl von Stufen versehen ist, einschließlich einer ersten Stufe (34), die mit den Bitleitungen gekoppelt ist, wobei die Bits des Bitleitungs-Auswahlsignals an die Stufen geliefert werden und wobei jede der Stufen eine Anzahl von n-Kanal-Feldeffekttransistoren (36 - 41) aufweist, die jeweils mit den Bitleitungen gekoppelt sind, und eine Inverterschaltung (35), die mit jedem der Bits versorgt wird, wobei jedes der Bits der Gateelektrode jedes zweiten der n-Kanal-Feldeffekttransistoren jeder Stufe zugeführt wird und die Inverterschaltung mit den Gateelektroden der anderen n-Kanal-Feldeffekttransistoren jeder Stufe verbunden ist.

3. Halbleiterspeichervorrichtung nach Anspruch 2,
wobei die Entladungsschaltung (17) eine Anzahl n-Kanal-Feldeffekttransistoren (41 - 46) aufweist, die mit den Bitleitungen gekoppelt sind, wobei die n-Kanal-Feldeffekttransistoren der Entladungsschaltung den n-Kanal-Feldeffekttransistoren der ersten Stufe hinsichtlich der Bitleitungen entsprechen und wobei alle n-Kanal-Feldeffekttransistoren der Entladungsschaltung an ihren anderen Enden mit einem Masseanschluß verbunden sind, wobei die n-Kanal-Feldeffekttransitoren der Entladungsschaltung den n-Kanal-Feldeffekttransistoren der ersten Stufe entsprechen, die mit dem Bit des Bitleitungs-Auswahlsignals versorgt werden mit ihren Gate-Elektroden mit den Inverterschaltungen der ersten Stufe gekoppelt sind und die anderen n-Kanal-Feldeffekttransistoren der Entladungsschaltung mit dem Bit des Bitleitungs-Auswahlsignals versorgt werden.

## Revendications

1. Dispositif à mémoire semi-conductrice fabriqué sur un substrat de semi-conducteur (11), comprenant :
a) une multitude de cellules mémoires (12) disposées en lignes et colonnes et susceptibles d'enregistrer des bits d'information ;
b) une multitude de lignes de bits (28 à 33) respectivement couplées aux colonnes des cellules mémoires pour protéger les bits d'information lues à partir des cellules mémoires, chacune sélectionnée à partir de chaque colonne ;
c) une multitude de lignes de mots (W₁ à Wₙ) respectivement couplées aux lignes des cellules mémoires, et sélectionnant une ligne de cellules mémoires pour délivrer les bits d'information aux lignes de bits ;
d) un circuit de décodeur d'adresses des lignes (13) permettant d'activer une des lignes de mots ;
e) un circuit de décodage d'adresses des colonnes (14) permettant de produire un signal de sélection de lignes de bits pour spécifier une des lignes de bits, le signal de sélection de lignes de bits ayant une multitude de bits ;
f) un circuit de sortie (16) permettant de mémoriser un des bits d'information sur une des lignes de bits, et
g) un circuit de sélection de colonnes (15) sensible au signal de sélection de lignes de bits et permettant de transférer un des bits d'information de la ligne de bits associée vers le circuit de sortie ;
caractérisé par
h) un circuit de décharge (17) permettant de coupler au moins les lignes de bits sur deux côtés et immédiatement adjacents à une des lignes de bits à une source de tension constante.

2. Dispositif à mémoire semi-conductrice selon la revendication 1, dans lequel le circuit de sélection de colonnes (15) est muni d'une multitude d'étages incluant un premier étage (34) couplé aux lignes de bits, les bits du signal de sélection de lignes de bits étant délivrés aux étages, respectivement, et dans lequel chacun des étages a une multitude de transistors à effet de champ de type à canal n (36 à 41) couplé aux lignes de bits, respectivement, et un circuit inverseur (35) alimenté par chacun des bits, dans lequel chacun des bits est envoyé à l'électrode de grille du deuxième transistor des transistors à effet de champ de type à canal n de chaque étage et le circuit inverseur est couplé aux électrodes de grille des autres transistors à effet de champ de type à canal n de chaque étage.

3. Dispositif à mémoire semi-conductrice selon la revendication 2, dans lequel le circuit de décharge (17) comprend une multitude de transistors à effet de champ de type à canal n (41 à 46) couplés aux lignes de bits, respectivement, les transistors à effet de champ de type à canal n du circuit de décharge correspondant aux transistors à effet de champ de type à canal n du premier étage en vue des lignes de bits, et dans lequel tous les transistors à effet de champ de type à canal n du circuit de décharge sont couplés à leur autre extrémité à la borne de masse, dans lequel les transistors à effet de champ de type à canal n du circuit de décharge correspondant aux transistors à effet de champ de type à canal n du premier étage alimenté avec le bit du signal de sélection de lignes de bits sont couplés aux électrodes de grille de ceux-ci au circuit inverseur du premier étage et les autres transistors à effet de champ de type à canal n du circuit de décharge sont alimentés avec le bit du signal de sélection de lignes de bits.
